# EUROPEAN PATENT APPLICATION

(11) **EP 3 133 662 A1**
(43) Date of publication of application: **22.02.2017**
(21) Application number: 16170571.0
(22) Date of filing: 20.05.2016
(51) Int. Cl.: H01L 51/52, H01L 51/56, H01L 27/32

(54) **DISPLAY APPARATUS AND METHOD OF MANUFACTURING THE SAME**

(30) Priority: 18.08.2015 KR 20150116165
(71) Applicant: LG Display Co., Ltd., Yeongdeungpo-gu Seoul 07336 (KR)
(72) Inventor: JUNG, YoungKwan, 10874 Paju-si, Gyeonggi-do (KR); CHOI, Hongseok, 05070 Seoul (KR); KIM, Seunghyun, 61684 Gwangju (KR)
(74) Representative: Viering, Jentschura & Partner mbB Patent- und Rechtsanwälte

(57) **Abstract**

A display apparatus (1000) according to an embodiment can include a first electrode (400), a plurality of organic layers, a second electrode (700), and a metal layer (600) disposed on a particular organic layer (POL) among the plurality of organic layers. The metal layer (600) is configured to protect the particular organic layer (POL) from being damaged when it is exposed to a non-vacuum environment at least once during processes of stacking the organic layers on the first electrode and the second electrode (700) on the organic layers in a vacuum environment, thereby suppressing a rise in the driving voltage of the display apparatus. Accordingly, the problems that the driving voltage of the display apparatus increases and the lifespan is shortened can be addressed.

## Description

### CROSS-REFERENCE TO RELATED APPLICATIONS

This application claims the priority of Korean Patent Application No. 10-2015-0116165 filed on August 18, 2015, in the Korean Intellectual Property Office, the disclosure of which is incorporated herein by reference.

### BACKGROUND

### Technical Field

The present disclosure relates to a display apparatus and a method of manufacturing the same. More specifically, the present disclosure relates to a display apparatus that suppresses a rise in driving voltage and improves processing stability by way of disposing a metal layer on a particular organic layer to thereby protect an organic layer from being damaged when it is exposed to a non-vacuum environment during the manufacturing process, and relates to a method of manufacturing the same.

### Description of the Related Art

Display apparatuses are used in a variety of devices such as televisions, mobile devices, laptop computers, vehicles, watches, etc.

Among others, an organic light-emitting display (OLED) apparatus is a self-luminance display apparatus and is emerging as the next generation display apparatus. Accordingly, an OLED apparatus, unlike a liquid-crystal display (LCD) device, does not require a separate light source and thus it can be made lighter and thinner. In addition, an OLED apparatus exhibits better performance over an LCD device in terms of viewing angle, contrast, response time, power consumption, etc., and thus is in the spotlight.

### SUMMARY

An OLED apparatus utilizes the phenomenon where holes and electrons injected from two electrodes recombine in an emission layer to form excitons, and light of a particular wavelength is generated as an energy is released when the excitons relax from an excited state to the ground state. In this manner, an OLED apparatus has self-luminance characteristics.

In order to improve the properties of an OLED apparatus such as the driving voltage or the luminous efficiency, additional organic layers having various functions may be further disposed between the two electrodes of the OLED apparatus, as well as the emission layer. For example, a hole injection layer or a hole transport layer may be additionally disposed between one of the two electrodes, i.e., an anode and an organic emission layer, in order to facilitate injection or transport of holes from the anode to the emission layer. In addition, an electron injection layer or an electron transport layer may be additionally disposed between a cathode and the organic emission layer, in order to facilitate injection or transport of electrons from the cathode to the emission layer. The additional organic layers disposed between the respective two electrodes and the emission layer reduces a difference in energy level between each of the two electrodes and the emission layer to facilitate movement of holes or electrons. Accordingly, the driving voltage of an OLED apparatus can be decreased or the luminous efficiency can be improved.

During the manufacturing process of such an OLED apparatus including a plurality of organic layers, the first electrode, the plurality of organic layers and the second electrode may not be deposited on one another in a single chamber or a deposition device due to the manufacturing environment or the limited performance of the manufacturing equipment. As a result, some of the plurality of organic layers may be exposed to a non-vacuum environment at least once. If some of the plurality of organic layers are exposed to the non-vacuum environment, e.g., a gas such as nitrogen N₂ or oxygen O₂, the organic material thereof may be easily damaged or transmuted, such that the properties of the material may be degraded. As a result, the driving voltage of the OLED apparatus increases, resulting in a problem that the lifespan of the display apparatus is shortened.

In particular, an organic layer of the plurality of organic layers which is disposed between the cathode and the emission layer, e.g., the material of the electron injection layer or the electron transport layer may have a structure that is more vulnerable to a gas such as nitrogen (N₂) or oxygen (O₂) than an organic layer disposed between the anode and the emission layer, e.g., the material of the hole injection layer or the hole transport layer. Further, during the process of depositing the cathode on the electron injection layer or the electron transport layer, the electron injection layer or the electron transport layer made of an organic material may be easily damaged by the cathode made of an inorganic material.

The inventors of the present application have recognized the above-mentioned problems and limitations and have studied on a structure that can ensure stability of organic layers in a deposition environment. As a result, the inventors have devised a novel display apparatus that solves or addresses the issue of rise in the driving voltage, and elongates the lifespan of the display apparatus.

Therefore, an aspect of the present disclosure is to provide a new display apparatus based upon the recognition that a particular organic layer can be transmuted or damaged by being exposed to a non-vacuum environment at least once during the manufacturing process. Such issue is addressed and effectively resolved by disposing a metal layer on the particular organic layer among multiple organic layers.

It should be noted that aspects of the present disclosure are not limited to the above-described, and other aspects of the present disclosure will be apparent to those skilled in the art from the following descriptions.

According to an aspect of the present disclosure, there is provided a display apparatus comprising a first electrode; a second electrode; a plurality of organic layers between the first electrode and the second electrode; and a metal layer located on a particular organic layer among the plurality of organic layers. The metal layer is configured to minimize a rise in a driving voltage of the display apparatus which causes damage to the particular organic layer when the particular organic layer among the plurality of organic layers is exposed to a non-vacuum environment at least once during the processes of stacking the plurality of organic layers and the second electrode on the first electrode. Accordingly, the problems that the driving voltage of the display apparatus increases and the lifespan is shortened can be solved or minimized.

In one or more embodiments, the plurality of organic layers comprises an emission layer, and the particular organic layer is positioned between the emission layer and the second electrode.

In one or more embodiments, the metal layer is configured to protect the particular organic layer, and act as an auxiliary electrode for additionally supplying electrons to the emission layer.

In one or more embodiments, the particular organic layer is made of a material that is more likely to be damaged by nitrogen or oxygen than that of an organic layer among the plurality of organic layers, which is between the emission layer and the first electrode.

In one or more embodiments, the particular organic layer has improved electronic characteristics than the organic layer between the emission layer and the first electrode.

In one or more embodiments, the particular organic layer is configured to inject or transport electrons to the emission layer.

In one or more embodiments, the metal layer has a thickness determined based on a degree of potential damage to the particular organic layer and transmittance of light emitted from the emission layer.

In one or more embodiments, the thickness of the metal layer is between 10 Å and 40 Å.

In one or more embodiments, an average transmittance of the metal layer is 90% or higher in a range of visible ray area.

In one or more embodiments, the light emitted from the emission layer exits by penetrating the second electrode.

In one or more embodiments, layers between the first electrode and the particular organic layer are stacked through an in-line process.

In one or more embodiments, the first electrode comprises a reflective layer and a transparent layer.

In one or more embodiments, the first electrode comprises a reflective layer and a transparent layer; the plurality of organic layers comprise: a first organic layer on the first electrode; at least one emission layer on the first organic layer; and a second organic layer, which is the particular organic layer, on the at least one emission layer, the second organic layer being made of a material having a higher electron mobility or electron affinity than that of the first organic layer; the metal layer is in contact with the second organic layer; and the second electrode comprises a transparent layer and is on the metal layer, wherein, preferably, a thickness of the metal layer is between 10 Å and 40 Å, wherein, further preferably, a transmittance of the metal layer is 90% or higher. The first organic layer may be a hole transport layer or a hole injection layer, and the second organic layer may bean electron transport layer or an electron injection layer.

According to another aspect of the present disclosure, there is provided a display apparatus comprising a first electrode comprising a reflective layer and a transparent layer; a first organic layer on the first electrode; at least one emission layer on the first organic layer; a second organic layer on the emission layer, the second organic layer being made of a material having a higher electron mobility or electron affinity than that of the first organic layer; a metal layer on and in contact with the second organic layer; and a second electrode comprising a transparent layer on the metal layer. Accordingly, the problem that the organic material is transmuted such that the driving voltage of the display apparatus increases or the lifespan of the display apparatus is shortened can be solved or minimized.

In one or more embodiments, a thickness of the metal layer is between 10 Å and 40 Å.

In one or more embodiments, a transmittance of the metal layer is 90% or higher.

In one or more embodiments, the first organic layer is a hole transport layer or a hole injection layer, and the second organic layer is an electron transport layer or an electron injection layer.

In one or more embodiments, the metal layer is configured to minimize damage of the second organic layer occurring when the second organic layer is exposed to a non-vacuum environment.

According to another aspect of the present disclosure, there is provided a method of manufacturing a display apparatus comprising forming a thin-film transistor on a substrate; forming a first electrode to be connected to a source electrode or a drain electrode of the thin-film transistor; forming a first organic layer on the first electrode; forming at least one emission layer on the first organic layer; forming a second organic layer on the emission layer, the second organic layer being made of a material having improved electronic characteristics than that of the first organic layer; forming a metal layer contacting with the second organic layer on the second organic layer; and forming a second electrode on the metal layer. The forming the first organic layer, the forming the emission layer, the forming the second organic layer and the forming the metal layer are performed through an in-line process. As a result, it is possible to suppress the second organic layer from being transmuted or damaged during the manufacturing process, such that the problem that the driving voltage increases can be solved/minimized and the processing stability can be improved.

In one or more embodiments, the method further comprises exposing the metal layer to a non-vacuum environment at least once between the forming the metal layer and the forming the second electrode.

In one or more embodiments, the metal layer is configured to suppress the second organic layer from being damaged when exposed to the non-vacuum environment, suppress the second organic layer from being damaged during the forming the second electrode, and act as an auxiliary electrode for additionally supplying electrons to the emission layer.

According to an exemplary embodiment of the present disclosure, a metal layer is disposed on a particular organic layer among a plurality of organic layers between two electrodes, such that the particular organic layer can be protected effectively from being transmuted or damaged even if the particular organic layer is exposed to a non-vacuum environment during the manufacturing process.

As a result, the processing stability of the display apparatus can be improved.

In addition, the metal layer is disposed between a cathode and an emission layer, e.g., on an electron injection layer or an electron transport layer, such that a damage to the electron injection layer or the electron transport layer by the cathode can be reduced. Moreover, the metal layer can also work as an auxiliary electrode for supplying electric charges to the emission layer, thereby improving the luminous efficiency of the display apparatus.

Accordingly, the problem that the organic material is transmuted such that the driving voltage of the display apparatus increases and the lifespan of the display apparatus is shortened can be solved or minimized.

It should be noted that effects of the present disclosure are not limited to those described above and other effects of the present disclosure will be apparent to those skilled in the art from the following descriptions.

The Summary is not to specify essential features of the appended claims, and thus the scope of the claims is not limited thereby.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a cross-sectional view of a display apparatus according to an exemplary embodiment of the present disclosure;
FIG. 2 is a cross-sectional view of an example of portion A of FIG. 1;
FIG. 3 is a cross-sectional view of another example of portion A of FIG. 1;
FIGS. 4A to 4B are a flowchart and a cross-sectional view, respectively, for illustrating a method of manufacturing a display apparatus according to an exemplary embodiment of the present disclosure;
FIG. 5A is a photograph of a cross-section of elements of a light-emitting device according to an exemplary embodiment of the present disclosure; and
FIG. 5B is a table showing driving voltages of Comparative Example and exemplary embodiments 1 and 2 of the present disclosure.

### DETAILED DESCRIPTION OF THE PREFERRED EMBODIMENTS

Advantages and features of the present disclosure and methods to achieve them will become apparent from the descriptions of exemplary embodiments hereinbelow with reference to the accompanying drawings. However, the present disclosure is not limited to exemplary embodiments disclosed herein but may be implemented in various different ways. The exemplary embodiments are provided for making the disclosure thorough and for fully conveying the scope of the present disclosure to those skilled in the art. It is to be noted that the scope of the present disclosure is defined only by the claims.

The figures, dimensions, ratios, angles, the numbers of elements given in the drawings are merely illustrative and are not limiting. Like reference numerals denote like elements throughout the descriptions. Further, in describing the present disclosure, descriptions on well-known technologies may be omitted in order not to obscure the gist of the present disclosure.

It is to be noticed that the terms "comprising," "having," "including" and so on, used in the description and claims, should not be interpreted as being restricted to the means listed thereafter unless specifically stated otherwise. Where an indefinite or definite article is used when referring to a singular noun, e.g. "a," "an, " "the, " this includes a plural of that noun unless specifically stated otherwise.

In describing elements, they are interpreted as including error margins even without explicit statements.

In describing positional relationship, such as "an element A on an element B, " "an element A above an element B, " "an element A below an element B" and "an element A next to an element B," another element C may be disposed between the elements A and B unless the term "directly" or "immediately" is explicitly used.

In describing temporal relationship, terms such as "after, " "subsequent to, " "next to" and "before" are not limited to "directly after," "directly subsequent to," "immediately next to" "immediately before," and so on, unless otherwise specified.

The terms first, second, third and the like in the descriptions and in the claims are used for distinguishing between similar elements and not necessarily for describing a sequential or chronological order. These terms are used to merely distinguish one element from another. Accordingly, as used herein, a first element may be a second element within the technical idea of the present disclosure.

The drawings are not to scale and the relative dimensions of various elements in the drawings are depicted schematically and not necessarily to scale.

Features of various exemplary embodiments of the present disclosure may be combined partially or totally. As will be clearly appreciated by those skilled in the art, technically various interactions and operations are possible. Various exemplary embodiments can be practiced individually or in combination.

Hereinafter, exemplary embodiments of the present disclosure will be described in detail with reference to the accompanying drawings.

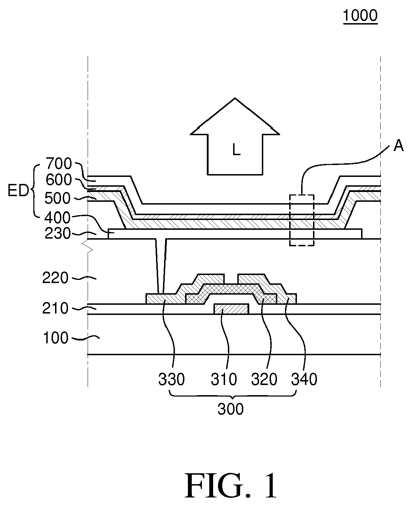

FIG. 1 is a cross-sectional view of a display apparatus 1000 according to an exemplary embodiment of the present disclosure. All the components of the display apparatus according to all embodiments of the present disclosure are operatively coupled and configured.

Referring to FIG. 1, the display apparatus 1000 includes a thin-film transistor 300 and a light-emitting device ED.

The thin-film transistor 300 is disposed on a substrate 100 and supplies a signal to the light-emitting device ED. The thin-film transistor 300 shown in FIG. 1 may be a driving thin-film transistor connected to a first electrode 410 of the light-emitting device ED. A switching thin-film transistor for driving the light-emitting device ED, a capacitor, etc., may be further disposed on the substrate 100.

The substrate 100 may be made of an insulative material such as glass or a flexible film made of a polyimide-based material.

The thin-film transistor 300 includes a gate electrode 310, an active layer 320, a source electrode 330, and a drain electrode 340. Referring to FIG. 1, the gate electrode 310 is formed on the substrate 100, and a gate insulation layer 210 covers the gate electrode 310. The active layer 320 is disposed on the gate insulation layer 210 such that it overlaps the gate electrode 310. The source electrode 330 and the drain electrode 340 are disposed on the active layer 320 such that they are spaced apart from each other.

As used herein, the expression "one element overlaps another element" preferably means that two elements at least partially overlap with one another in a vertical (or substantially vertical) direction (e.g., stacked or layered) with or without another element therebetween. Various other expressions may also be used.

The gate electrode 310, the source electrode 330 and the drain electrode 340 may be made of a conductive material including, but is not limited to, one of molybdenum (Mo), aluminum (Al), chrome (Cr), gold (Au), titanium (Ti), nickel (Ni), neodymium (Nd) and copper (Cu) or an alloy thereof.

The active layer 320 may be made of, but is not limited to, one among an amorphous silicon (a-Si), a polycrystalline silicon (poly-Si), oxide and organic materials depending on the type of the active layer 320. Two or more different types of thin-film transistors (TFTs) having respectively different types of active layer material may be implemented onto a single substrate to achieve the TFT array and/or be used in other components that require transistors. For example, transistors with an active layer made of low temperature poly-silicon (LTPS) exhibit relatively high electron mobility and are stable, despite some drawbacks in uniformity and high costs. On the other hand, transistors with an active layer made of oxide material exhibit uniform characteristics and require relatively low costs in manufacturing, although electron mobility is relatively low and have some leakage current issues. Such TFT characteristics allow different components in a display panel to be made of TFT having different types of active layers.

The gate insulation film 210 may be made up of a single layer or a plurality of layers made of inorganic material, for example, silicon oxide (SiOₓ) and silicon nitride (SiNₓ).

Although the thin-film transistor 300 is shown as a staggered thin-film transistor in FIG. 1, this is merely illustrative. For example, the thin-film transistor 300 may be a coplanar thin-film transistor.

A planarization layer 220 is disposed over the thin-film transistor 300, via which a part of the source electrode 330 is exposed. The planarization layer 220 may be a single layer or a plurality of layers and may be made of organic material. Specifically, the planarization layer 220 may be made of polyimide, acryl, etc.

Another passivation layer may be further formed between the planarization layer 220 and the thin-film transistor 300. The passivation layer may be made of inorganic material and may protect the thin-film transistor 300. Similarly to the planarization layer 220, a part of the source electrode 330 may be exposed via the passivation layer.

The light-emitting device ED is disposed on the planarization layer 220 and includes a first electrode 400, a light-emitting region 500, a metal layer 600 and a second electrode 700. The display apparatus 1000 according to the exemplary embodiment of the present disclosure is of a top emission type, and accordingly light L emitted from the light-emitting region 500 exits via the second electrode 700.

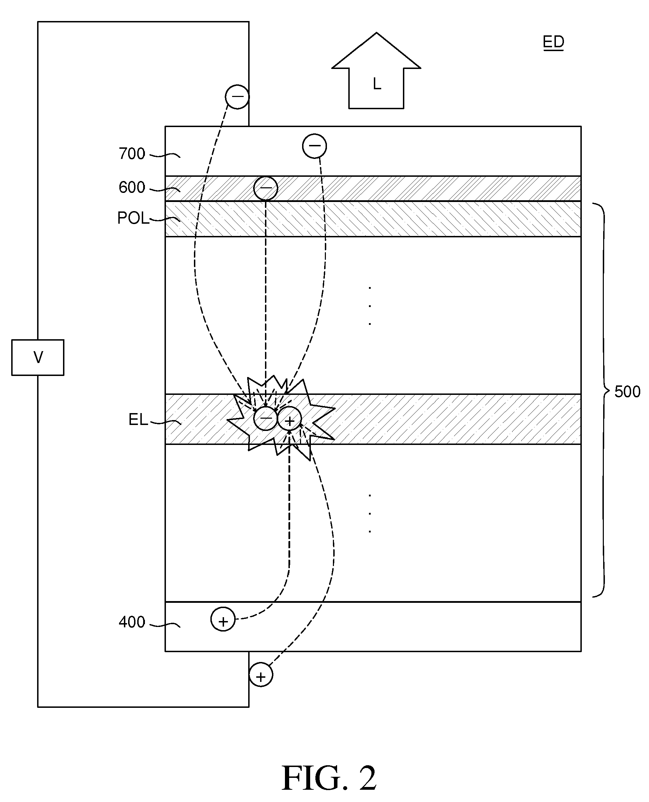

FIG. 2 is a cross-sectional view of an example of portion A of FIG. 1. Specifically, FIG. 2 is a schematic cross-sectional view illustrating one or more relevant elements of the light-emitting device ED of the display apparatus.

Referring to FIG. 2, the light-emitting device ED of the display apparatus 1000 includes the first electrode 400, the light-emitting region 500 and the second electrode 700. The light-emitting region 500 refers to a plurality of organic layers or a structure of a plurality of organic layers located between the first electrode 400 and the second electrode 700. In addition, the display apparatus 1000 may be referred to as an organic light-emitting display (OLED) apparatus that includes the light-emitting device ED having self-luminance characteristics.

The first electrode 400 is disposed in every pixel, spaced apart from one another. The first electrode 400 supplies or transfers holes to the light-emitting region 500 and is connected to the source electrode 330 of the respective thin-film transistor 300. The first electrode 400 may be referred to as an anode or a patterned electrode. The first electrode 400 may be connected to the drain electrode 340 depending on the type of the thin-film transistor 300.

The second electrode 700 is shared by a plurality of pixels. The second electrode 700 supplies or transfers electrons to the light-emitting region 500. Since the second electrode 700 has to transmit the light emitted from the light-emitting region 500, the second electrode 700 may be made of a very thin metal material or a transparent material. The second electrode 700 may be referred to as a cathode or a common electrode.

The plurality of organic layers of the light-emitting region 500 includes an emission layer EL. The emission layer EL may be patterned for every pixel(s) using a mask such as a fine metal mask (FMM), or may be shared by the plurality of pixels. The emission layer EL emits light by combining holes and electrons therein. The color of the emitted light may vary depending on the material of the emission layer EL. Specifically, referring to FIG. 2, upon applying a voltage V across the first electrode 400 and the second electrode 700, the holes supplied from the first electrode 400 or the holes supplied by the voltage applied to the first electrode 400 may be transferred to the emission layer EL via the first electrode 400. In addition, the electrons supplied from the second electrode 700 or the electrons supplied by the voltage applied to the second electrode 700 are transferred to the emission layer EL via the second electrode 700. The transferred electrons and holes combine in the emission layer EL to emit light. The emitted light exits upwardly via the second electrode 700. The voltage V shown in FIG. 2 is for driving the light-emitting device ED. The level of the voltage V may vary depending on the design of the light-emitting device ED and the display apparatus 1000.

The display apparatus 1000 according to the exemplary embodiment of the present disclosure includes a metal layer 600 located on a particular organic layer (referred to as "POL" hereafter) among the plurality of organic layers of the light-emitting region 500.

The particular organic layer (POL), which is one of the plurality of organic layers, may be exposed to a non-vacuum environment at least once during the processes of stacking the plurality of organic layers on the first electrode 400 and the second electrode 700 on the plurality of organic layers, unless the metal layer 600 is disposed on the POL as in the present disclosure. If the POL is exposed within a non-vacuum environment, e.g., with a gas such as nitrogen N₂ or oxygen O₂ in a chamber (as is done in the related art), the organic material of the POL may be easily transmuted or damaged, such that the material characteristics may be degraded. Such degradation of the material characteristics of the POL can mean degradation of the performance of the light-emitting region 500. As a result, the driving voltage of the display apparatus according to the related art may increase, resulting in a serious problem that the lifespan of the display apparatus may be shortened. The structure and configuration of the display apparatus 1000 as shown in FIG. 2 address these limitations associated with the related art.

In addition, as shown in FIG. 2, the POL is disposed between the second electrode 700 and the emission layer EL and facilitates the injection or transport of the electrons supplied from the second electrode 700 or the electrons supplied via the second electrode 700 to the emission layer EL. The POL is made of a material having better electronic characteristics than the organic layers between the first electrode 400 and the emission layer EL, e.g., improved electron affinity or electron mobility. Accordingly, the material of the POL may be easily damaged by nitrogen or oxygen. Therefore, if the POL is exposed to a non-vacuum environment during the process of depositing the emission layer EL, the characteristics of the emission layer EL may be further degraded. In this regard, the material having high electron affinity or high electron mobility reduces energy barrier against electron injection to thereby increase the efficiency of electron injection or transport. The material may have a low LUMO (lowest unoccupied molecular orbitals) level.

In the display apparatus 1000 according to an exemplary embodiment of the present disclosure, the metal layer 600 is located on the POL so as to suppress the problem that the POL is exposed to a non-vacuum environment during the manufacturing process to be damaged such that the driving voltage of the display apparatus 1000 increases.

The metal layer 600 is made of a metal material that is less likely to be damaged by a gas such as nitrogen and oxygen, compared to the POL. Therefore, even if the metal layer 600 is exposed to a non-vacuum environment during the manufacturing process for a certain period of time, the characteristics of the light-emitting device ED may not be affected or are rarely affected thereby.

In addition to the function of protecting the POL, the metal layer 600 may also work as an auxiliary electrode for additionally supplying electrons to the emission layer EL. As mentioned earlier, when a voltage is applied to the light-emitting device ED, electrons are supplied from the second electrode 700 to the emission layer EL or electrons supplied by the voltage applied to the second electrode 700 are transferred to the emission layer EL via the second electrode 700. In addition, since the metal layer 600 is made of a metal material having a high work function, additional electrons may be supplied from the metal layer 600 to the emission layer EL. Accordingly, the supply of electrons to the emission layer EL is further facilitated, and thus the luminous efficiency of the light-emitting device ED can be improved.

The metal layer 600 according to the exemplary embodiment of the present disclosure suppresses damage to the light-emitting region 500 made up of a plurality of organic layers by the second electrode 700 during the process of depositing the second electrode 700 on the light-emitting region 500. In other words, if the metal layer 600 is not disposed, the POL may be damaged while the second electrode 700 made of inorganic material is deposited on the POL. Once the POL is damaged, the material characteristics may be degraded, and thus the capability of injecting or transferring electrons may deteriorate. The metal layer 600 according to the exemplary embodiment of the present disclosure can suppress damage to the plurality of organic layers, especially the POL during the formation of the second electrode 700.

The thickness of the metal layer 600 may be determined based on a trade-off between the damage to the POL and the transmittance of light emitted from the emission layer EL. More specifically, the thickness of the metal layer 600 may be so determined that it suppresses damage to the POL when the POL is exposed to a non-vacuum environment, e.g., exposed to a gas such as nitrogen or oxygen. At the same time, the thickness of the metal layer 600 may be so determined that it suppresses damage to the POL during the process of depositing the second electrode 700 on the POL. In addition, the thickness of the metal layer 600 may be so determined that it suppresses damage to the POL during the process of forming the metal layer 600 on the POL. In addition, the thickness of the metal layer 600 may be so determined that it does not substantially affect the transmittance of the light L which is emitted from the emission layer EL to exit via the second electrode 700.

As described above, as the metal layer 600 becomes thicker, the POL can be less affected by external environment, but unpredicted damage may be exerted to the POL during the process of depositing the metal layer 600 on the POL. Further, since the metal layer 600 is made of a metal material, the transmittance of the light L becomes lower as the metal layer 600 becomes thicker. Accordingly, the luminous efficiency of the light-emitting device ED has to be taken into account in determining the thickness. That is, if the display apparatus 1000 is for a high performance applications or usage requiring high luminous efficiency of the light-emitting device ED, the thickness of the metal layer 600 may be so determined that the POL is sufficiently protected while compromising the transmittance of the light L as little as possible. In contrast, if the display apparatus 1000 is for relatively low performance applications or usage, there is more design freedom in determining the thickness of the metal layer based on the trade-off between the transmittance of the light L and damage to the POL. For example, the metal layer 600 may have a thickness between 10 Å and 40 Å, more preferably between 30 Å and 40 Å. In addition, the metal layer 600 may have an average transmittance of 90% or higher in the range of visible ray, i.e., approximately from 380 nm to 800 nm.

As described above, in the display apparatus 1000 according to the exemplary embodiment of the present disclosure, the metal layer 600 is located on the POL such that it suppresses the POL from being exposed to a non-vacuum environment at least once during the processes of stacking the plurality of organic layers on the first electrode 400 and the second electrode 700 on the organic layers in the vacuum environment to be damaged, resulting in rise in the driving voltage of the display apparatus 1000. As a result, the POL can be effectively protected so that it is neither transmuted nor damaged even if the POL is exposed to the non-vacuum environment during the manufacturing processing, thereby improving the processing stability of the display apparatus 1000. In addition, damage to the POL possibly occurring during the process of depositing the second electrode 700 on the POL can also be suppressed or minimized. Moreover, the metal layer 600 can work as an auxiliary electrode for supplying electric charges to the emission layer EL, thereby improving the luminous efficiency of the display apparatus 1000. Accordingly, the problem that the POL is transmuted such that the driving voltage of the display apparatus 1000 increases or the lifespan of the display apparatus is shortened can be addressed.

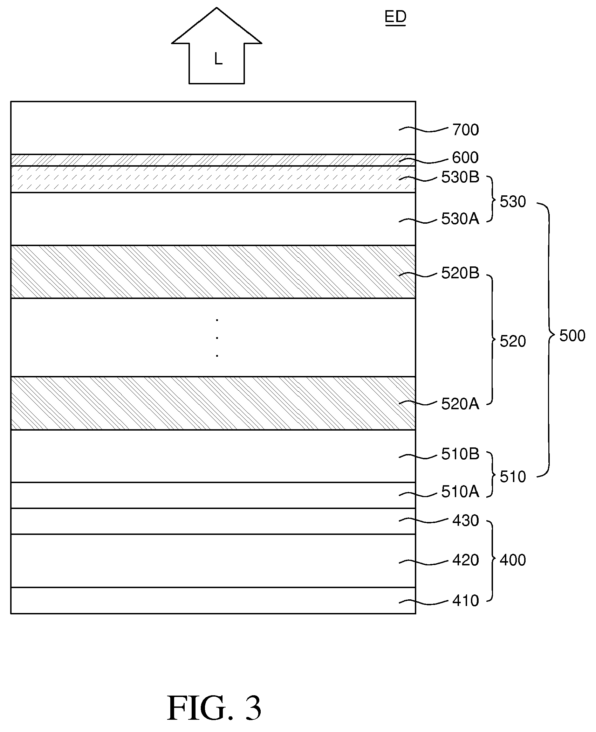

FIG. 3 is a cross-sectional view of another example of portion A of FIG. 1. Specifically, FIG. 3 is a view illustrating one or more relevant elements of a light-emitting device ED of a display apparatus. For convenience of illustration, the same or similar elements as those described in the above exemplary embodiment may not be described or the description thereof will be brief. FIG. 3 shows an exemplary embodiment to which the technical idea of the above exemplary embodiment is applied, and thus is not limiting. It will be understood that the structure of the light-emitting device ED of the display apparatus 1000 can be modified in a variety of ways without departing from the technical ideas of the present disclosure.

Referring to FIG. 3, the light-emitting device ED of the display apparatus 1000 includes the first electrode 400, the light-emitting region 500 and the second electrode 700. The display apparatus 1000 shown in FIG. 3 is of a top emission type, and accordingly light L emitted from the light-emitting portion 500 exits via the second electrode 700.

The first electrode 400 includes a reflective layer so that the light L emitted from the light-emitting region 500 does not exit downwardly via the first electrode 400. Specifically, as shown in FIG. 3, the first electrode 400 may have a three-layer structure in which a first transparent layer 410, a reflective layer 420 and a second transparent layer 430 are provided in this order. The first transparent layer 410 and the second transparent layer 430 may be made of a transparent conductive oxide (TCO) such as indium tin oxide (ITO) and indium zinc oxide (IZO). The reflective layer 420 between the two transparent layers 410 and 430 may be made of a metal material such as copper (Cu), silver (Ag), and palladium (Pd), for example. The first electrode 400 may have a two-layer structure of a reflective layer and a transparent layer.

Since the second electrode 700 has to transmit or pass the light L emitted from the light-emitting region 500, the second electrode 700 may be made of a thin metal material, e.g., from 150Å to 250Å or a transparent material. For example, the second electrode 700 may be made of a transparent conductive oxide (TCO) such as indium tin oxide (ITO) and indium zinc oxide (IZO) or a metal material such as silver (Ag) and magnesium (Mg). For example, the second electrode 700 is made of a transparent material such as transparent conductive oxide (TCO) so that the second electrode 700 decreases the transmittance of the light L emitted from the light-emitting region 500 as little as possible.

A first organic layer 510, an emission layer 520, a second organic layer 530 and a metal layer 600 are located in this order between the first electrode 400 and the second electrode 700.

The first organic layer 510 is located on the first electrode 400, specifically, between the first electrode 400 and the emission layer 520 and facilitates the supply of the holes to the emission layer 520. As shown in FIG. 3, the first organic layer 510 may include a hole injection layer 510A and a hole transport layer 510B.

The hole injection layer 510A is disposed on the first electrode 400 and facilitates the injection of the holes from the first electrode 400 or the holes supplied via the first electrode 400 to the emission layer 520. The hole injection layer 510A may be made of, but is not limited to, MTDATA(4,4',4"-tris(3-methylphenylphenylamino)triphenylamin e), CuPc(copper phthalocyanine) or PEDOT/PSS(poly(3,4-ethylenedioxythiophene), polystyrene sulfonate). In addition, the hole injection layer 510A may have a thickness between approximately 30 Å and 100 Å.

The hole transport layer 510B is disposed on the hole injection layer 510A and facilitates the transport of the holes from the first electrode 400 or the holes supplied via the first electrode 400 to the emission layer 520. The hole transport layer 510B may be made of, but is not limited to, TPD(N,N'-diphenyl-N,N'-bis(3-methylphenyl)-1,1'-bi-phenyl-4 ,4'-diamine) or NPB(N,N'-di(naphthalen-1-yl)-N,N'-diphenyl-benzidine).

The first organic layer 510 may further include a p-type hole transport layer doped with a p-type dopant or may be made up of a single layer rather than a plurality of layers depending on various factors.

The emission layer 520 is located on the first organic layer 510 and may be made of at least one layer. The emission layer 520 may emit light of white or light of a single color such as red, green and blue depending on the design of the display apparatus 1000 and may be made up of a single layer or a plurality of layers. For example, as shown in FIG. 3, the emission layer 520 may include a blue emission layer 520A and a yellow-green emission layer 520B for emitting light of white. If the emission layer 520 is made up of a plurality of layers, a charge generation layer may be further disposed between the plurality of layers.

The second organic layer 530 is located on the emission layer 520, specifically, between the second electrode 700 and the emission layer 520 and facilitates the supply of the electrons to the emission layer 520. As shown in FIG. 3, the second organic layer 530 may include an electron transport layer 530A and an electron injection layer 530B.

The electron transport layer 530A is disposed on the emission layer 520 and facilitates the transport of the electrons from the second electrode 700 or the electrons supplied via the second electrode 700 to the emission layer 520. The electron transport layer 530A may be made of, but is not limited to, oxadiazole, triazole, phenanthroline, benzoxazole or benzthiazole.

The electron injection layer 530B is disposed on the electron transport layer 530A and facilitates the injection of the electrons from the second electrode 700 or the electrons supplied via the second electrode 700 to the emission layer 520.

The second organic layer 530 is made of a material having better electronic characteristics than the first organic layer 510, e.g., better electron affinity or electron mobility. Accordingly, the second organic layer 530 may be more vulnerable to a gas such as nitrogen (N₂) or oxygen (O₂) than the first organic layer 510.

Accordingly, in an exemplary embodiment of the present disclosure, the metal layer 600 is disposed on the second organic layer 530, more specifically on the electron injection layer 530B, such that it is possible to suppress the problem that the electron injection layer 530B is exposed to a non-vacuum environment to be damaged during the manufacturing process. Accordingly, it is possible to suppress the material characteristics of the electron injection layer 530B from being degraded, which results in an undesired rise in the driving voltage of the display apparatus 1000. As a result, the lifespan of the display apparatus 1000 can be elongated and the processing stability during the deposition process can be improved.

The metal layer 600 is made of a metal material that is less likely to be damaged by a gas such as nitrogen and oxygen, compared to the electron injection layer 530B or the electron transport layer 530A, e.g., aluminum (Al). Therefore, even if the metal layer 600 is exposed to a non-vacuum environment during the manufacturing process for a certain period of time, the characteristics of the light-emitting device ED is rarely affected thereby.

In addition, since the metal layer 600 is made of a metal material having a high work function, it may work as an auxiliary electrode for additionally supplying electrons, thereby improving the luminous efficiency of the display apparatus 1000. Further, it is possible to suppress the problem that the electron injection layer 530B is damaged by the second electrode 700 made of inorganic material during the process of depositing the second electrode 700.

The thickness of the metal layer 600 may be determined based on a trade-off between the damage to the electron injection layer 530B and the transmittance of light L emitted from the emission layer 520. For example, the metal layer 600 may have a thickness between 10 Å and 40 Å, such as between 30 Å and 40 Å. In addition, the metal layer 600 may have an average transmittance of 90% or higher in the wavelength range of visible ray, e.g., approximately from 380 nm to 800 nm.

In FIG. 3, the second organic layer 530 is shown as a plurality of layers including the electron injection layer 530B and the electron transport layer 530A. However, the second organic layer 530 may be a single layer made of a material having high electron mobility or electron affinity. For example, the second organic layer 530 may be a single layer of a hole transporting layer. In that case, the metal layer 600 may be disposed on the hole transport layer to protect the hole transport layer, such that damage to the hole transport layer by external environment can be suppressed by the metal layer 600.

As described above, according to the exemplary embodiment of the present disclosure, the metal layer 600 suppresses damage to the electron injection layer 530B of the second organic layer 530 possibly occurring when the electron injection layer 530B is exposed to a non-vacuum environment, such that the problem that the driving voltage of the display apparatus 1000 increases or the lifespan is shortened as the organic material is transmuted or damaged can be addressed.

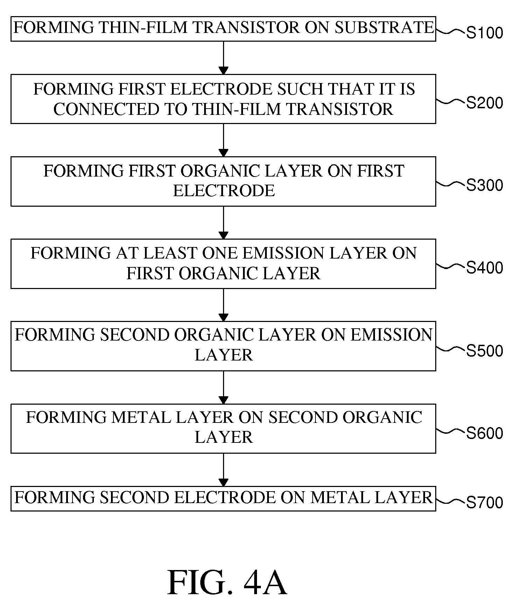

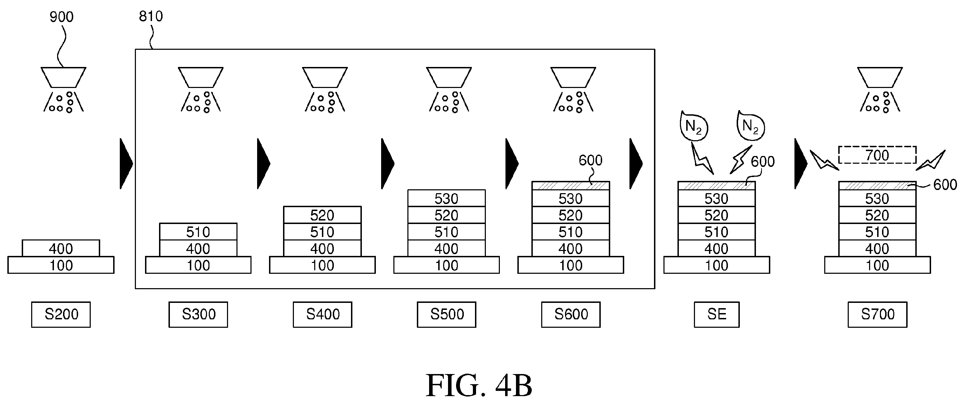

FIGS. 4A and 4B are a flowchart and a cross-sectional view, respectively, for illustrating a method of manufacturing a display apparatus according to an exemplary embodiment of the present disclosure. In describing this exemplary embodiment, descriptions on the same or similar elements as those in the above exemplary embodiments will be omitted.

Referring to FIG. 4A, there is provided a method of manufacturing a display apparatus including forming a thin-film transistor on a substrate (step S100), forming a first electrode such that it is connected to a source electrode or a drain electrode of the thin-film transistor (step S200), forming a first organic layer on the first electrode (step S300), forming at least one emission layer on the first organic layer (step S400), forming a second organic layer on the emission layer, the second organic layer being made of a material having better electronic characteristics than that of the first organic layer (step S500), forming a metal layer on the second organic layer (step S600), and forming a second electrode on the metal layer (step S700) . A more detailed description thereof will be made below with reference to FIG. 4B.

Initially, a thin-film transistor is formed on a substrate 100 (step S100) . A plurality of thin-film transistors including a driving thin-film transistor or a switching thin-film transistor may be formed on the substrate 100.

Subsequently, referring to FIG. 4B, a first electrode 400 is formed on the substrate 100 such that it is connected to the source electrode or the drain electrode of the thin-film transistor (step S200). The first electrode 400 may have a two-layer structure of a transparent layer and a reflective layer or may have a three-layer structure of a transparent layer, a reflective layer and a transparent layer. The first electrode 400 may be formed by ejecting a transparent material or a reflective material from a deposition source 900 onto the substrate 100 to deposit it. However, this is merely illustrative and a variety of processing schemes may be applied depending on the characteristics of the material of the first electrode 400.

Subsequently, a first organic layer 510, an emission layer 520, a second organic layer 530 and a metal layer 600 are stacked on one another in this order. Steps S300 to S600 are performed in a vacuum chamber 810 through a so-called in-line process. The first organic layer 510, the emission layer 520, the second organic layer 530 and the metal layer 600 may be formed by ejecting respective materials from the deposition source 900 to deposit them. However, this is merely illustrative and various processes may be employed depending on the characteristics of the material of each layer.

The first organic layer 510 facilitates the transport of the holes to the emission layer 520. The emission layer 520 may be made up of a single layer or a plurality of layers. The second organic layer 530 facilitates the transport of the electrons to the emission layer 520 and may be made of a material having better electronic characteristics than the first organic layer 510, e.g., better electron affinity or electron mobility. Accordingly, the second organic layer 530 may be more vulnerable to nitrogen (N₂) or oxygen (O₂) than the first organic layer 510.

The in-line process refers to a series of automated processing steps performed by special equipment, requiring minimum human intervention. Accordingly, "[s]teps S300 to S600 are performed in a vacuum chamber 810 through an in-line process" preferably means that the first organic layer 510, the emission layer 520, the second organic layer 530 and the metal layer 600 are formed sequentially and automatically by such equipment, unless abnormal situation such as malfunction takes place. Such processes are performed in the vacuum chamber 810.

As the number of steps for the in-line processing increases, a higher-level manufacturing environment for accommodating equipment or the like or development of equipment for operation is required. Accordingly, there may be more chances that the display apparatus is exposed to a non-vacuum environment at least once due to the manufacturing environment or the limited performance of the manufacturing equipment. For example, as shown in FIG. 4B, step SE during which the metal layer 600 is exposed to a non-vacuum environment at least once may be further included between step S600 of forming the metal layer 600 and step S700 of forming the second electrode 700. Step SE during which the display apparatus is exposed to a non-vacuum environment may correspond to a standby time before the process of forming the second electrode 700 is started or a time in which the substrate 100 moves from one equipment to another.

After the metal layer 600 has been formed on the second organic layer 500, the display apparatus may be exposed to a non-vacuum environment, e.g., gas such as nitrogen N₂ as shown in FIG. 4B. If the metal layer 600 is not formed on the second organic layer 530, the second organic layer 530 is directly affected by a gas when the display apparatus is exposed to a non-vacuum environment. As a result, the second organic layer 530 may be transmuted or damaged. Accordingly, without the structure and configuration of the display apparatus of the present disclosure, the driving voltage of the display apparatus may increase and the lifespan may be shortened.

The metal layer 600 of the display apparatus according to the present disclosure suppresses damage to the second organic layer 530 while the display apparatus is exposed to a non-vacuum environment at least once. That is, the second organic layer 530 is protected by the metal layer 600 and thus damage to the second organic layer 530 can be suppressed even if the display apparatus is exposed to a non-vacuum environment for a certain period of time.

In addition, the metal layer 600 is formed between the second organic layer 530 and the second electrode 700, and thus damage to the second organic layer 530 occurring during the process of forming the second electrode 700 (step S700) can also be suppressed. As shown in FIGS. 4A and 4B, the second electrode 700 may be formed by ejecting a transparent material or a metal material from a deposition source 900 to deposit it. However, this is merely illustrative and a variety of processing schemes may be applied depending on the characteristics of the material.

Moreover, the metal layer 600 formed between the second organic layer 530 and the second electrode 700 may work as an auxiliary electrode for additionally supplying electrons to the emission layer 520, thereby improving the luminous efficiency of the display apparatus.

As described above, the method of manufacturing a display apparatus according to the exemplary embodiment of the present disclosure includes forming the metal layer 600 on a particular organic layer, e.g., the second organic layer 530 such that the second organic layer 530 is suppressed from being damaged or transmuted while it is exposed to a non-vacuum environment at least once during the manufacturing process. By doing so, the processing stability during the manufacturing process of the display apparatus can be improved, and the problem that the driving voltage of the manufactured display apparatus increases can be solved.

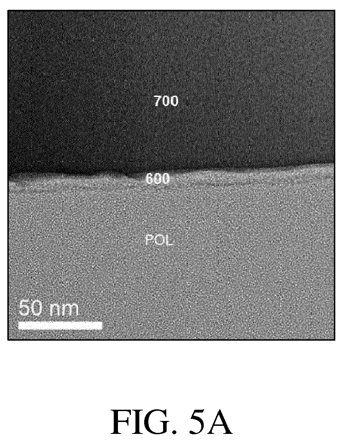

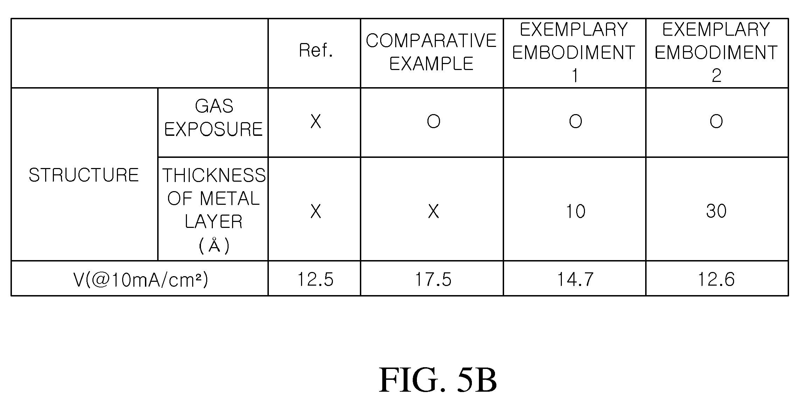

FIG. 5A is a photograph of a cross-section of elements of a light-emitting device according to an exemplary embodiment of the present disclosure. FIG. 5B is a table showing driving voltages of Comparative Example and exemplary embodiments of the present disclosure.

Referring to FIG. 5A, the photograph of the cross-section of a part of the light-emitting device including a metal layer according to an exemplary embodiment of the present disclosure was observed using a transmission electron microscope (TEM). It can be seen from the photograph that the metal layer 600 is disposed between the POL and the second electrode 700.

In the table shown in FIG. 5B, a reference specimen Ref. has a structure that does not include the metal layer 600 and has not been exposed to gas during the manufacturing process. It can be seen that the specimen has the driving voltage V of 12.5 V when the current of 10 mA/cm² is flowing therein.

In the table shown in FIG. 5B, a specimen in Comparative Example has the structure that does not include the metal layer 600 like the reference specimen Ref. However, the POL has been exposed to gas, e.g., oxygen, during the manufacturing process for certain period of time. It can be seen that the specimen has the driving voltage V of 17.5 V when the current of 10 mA/cm² is flowing therein. That is, the driving voltage V of the Comparative Example has been increased by 5 V compared to the reference specimen Ref.

In contrast, the specimen of the first exemplary embodiment of the present disclosure (Exemplary Embodiment 1) has a structure that includes the metal layer 600 between the POL and the second electrode 700, and the metal layer 600 has been exposed to oxygen O₂ during the manufacturing process for a certain period of time, like the specimen of Comparative Example. The metal layer 600 was made of aluminum (Al) material at the thickness of 10 Å. It can be seen that the specimen has the driving voltage V of 14.7 V when the current of 10 mA/cm² is flowing therein. That is, the driving voltage V of the first exemplary embodiment of the present disclosure has been decreased by 2.8 V compared to the specimen of Comparative Example. That is, it can be seen that the POL of the light-emitting device is protected by the metal layer 600 even if it is exposed to the gas during the manufacturing process for a certain period of time due to the manufacturing environment or the limited performance of the manufacturing equipment, such that the organic material was suppressed from being transmuted or damaged. As a result, it can be proven that the driving voltage was decreased by employing the metal layer 600.

The specimen of the second exemplary embodiment of the present disclosure (Exemplary Embodiment 2)has a structure that includes the metal layer 600 between the POL and the second electrode 700 like the specimen of the first exemplary embodiment of the present disclosure. However, the metal layer 600 was made of aluminum (Al) material at the thickness of 30 Å In addition, the specimen of the second exemplary embodiment of the present disclosure was exposed to oxygen O₂ during the manufacturing process for a certain period of time. It can be seen that the specimen has the driving voltage V of 12.6V when the current of 10 mA/cm² is flowing therein. That is, the driving voltage V of the second exemplary embodiment of the present disclosure has been increased by 4.9V compared to the specimen of Comparative Example. Further, it can also be seen that the driving voltage V of the second exemplary embodiment of the present disclosure has been decreased by 2.1V compared to the specimen of the first exemplary embodiment of the present disclosure with the metal layer 600 at the thickness of 10 Å. That is, it can be seen that the POL of the light-emitting device is protected by the metal layer 600 more effectively as the metal layer 600 is thicker even if it is exposed to the gas during the manufacturing process for a certain period of time, such that the organic material was further suppressed from being transmuted or damaged. In addition, the driving voltage V of the specimen of the second exemplary embodiment of the present disclosure was decreased even close to the driving voltage of the reference specimen Ref. that has not been exposed to gas. In other words, it can be seen that the POL is rarely affected by the gas by disposing the metal layer 600 thereon even if it is exposed to gas during the manufacturing process for a certain period of time due to the manufacturing environment or the limited performance of the manufacturing equipment, such that the processing stability can be significantly improved.

As described above, according to an exemplary embodiments of the present disclosure, the metal layer 600 is located between the POL and the second electrode 700 such that the metal layer 600 suppresses the POL from being damaged when it is exposed to a non-vacuum environment during the manufacturing process, which results in rise in the driving voltage. As a result, it is possible to suppress the POL from being transmuted or damaged during the manufacturing process, such that the problem that the driving voltage increases can be solved and the processing stability can be improved.

The exemplary embodiments of the present disclosure can also be described as follows.

According to an aspect of the present disclosure, a display apparatus can include a first electrode,-a second electrode, a plurality of organic layers between the first electrode and the second electrode; and a metal layer located on a particular organic layer among the plurality of organic layers, wherein the metal layer is configured to minimize a rise in driving voltage of the display apparatus which causes damage to the particular organic layer when the particular organic layer among the plurality of organic layers is exposed to a non-vacuum environment at least once during processes of stacking the plurality of organic layers and the second electrode on the first electrode. Accordingly, the problems that the driving voltage of the display apparatus increases and the lifespan is shortened can be addressed.

The plurality of organic layers may comprise an emission layer, and the particular organic layer may be positioned between the emission layer and the second electrode.

The metal layer may be configured to protect the particular organic layer, and act as an auxiliary electrode for additionally supplying electrons to the emission layer.

The particular organic layer may be made of a material that is more likely to be damaged by nitrogen or oxygen than that of an organic layer between the emission layer and the first electrode.

The particular organic layer may have improved electronic characteristics than the organic layer between the emission layer and the first electrode. The particular organic layer may be configured to inject or transport electrons to the emission layer.

The metal layer may have a thickness determined based on a degree of potential damage to the particular organic layer and transmittance of light emitted from the emission layer.

The thickness of the metal layer may be between 10 Å and 40 Å. The average transmittance of the metal layer may be 90% or higher in the range of visible ray area.

The light emitted from the emission layer may exit by penetrating the second electrode. Layers between the first electrode and the particular organic layer may be stacked through an in-line process. The first electrode may include a reflective layer and a transparent layer.

According to another aspect of the present disclosure, a display apparatus can include a first electrode having a reflective layer and a transparent layer, a first organic layer on the first electrode, at least one emission layer on the first organic layer, a second organic layer on the emission layer and being made of a material having a higher electron mobility or electron affinity than that of the first organic layer, a metal layer on and in contact with the second organic layer, and a second electrode having a transparent layer on the metal layer. Accordingly, the problem that the organic material is transmuted such that the driving voltage of the display apparatus increases or the lifespan of the display apparatus is shortened can be solved or minimized.

The thickness of the metal layer may be between 10 Å and 40 Å. The transmittance of the metal layer may be 90% or higher in the range of visible ray.

The first organic layer may be a hole transport layer or a hole injection layer, and the second organic layer may be an electron transport layer or an electron injection layer.

The metal layer may be configured to minimize damage of the second organic layer occurring when the second organic layer is exposed to a non-vacuum environment.

According to still another aspect of the present disclosure, a method of manufacturing a display apparatus can include forming a thin-film transistor on a substrate, forming a first electrode to be connected to a source electrode or a drain electrode of the thin-film transistor, forming a first organic layer on the first electrode, forming at least one emission layer on the first organic layer, forming a second organic layer on the emission layer where the second organic layer is made of a material having improved electronic characteristics than that of the first organic layer, forming a metal layer contacting with the second organic layer on the second organic layer, and forming a second electrode on the metal layer. The forming the first organic layer, the forming the emission layer, the forming the second organic layer and the forming the metal layer are performed through an in-line process. As a result, it is possible to suppress the second organic layer from being transmuted or damaged during the manufacturing process, such that the problem that the driving voltage increases can be solved and the processing stability can be improved.

The method may further comprise exposing the metal layer to a non-vacuum environment at least once between the forming the metal layer and the forming the second electrode.

The metal layer may be configured to suppress the second organic layer from being damaged when exposed to the non-vacuum environment, suppress the second organic layer from being damaged during the forming the second electrode, and act as an auxiliary electrode for additionally supplying electrons to the emission layer.

Thus far, exemplary embodiments of the present disclosure have been described in detail with reference to the accompanying drawings. However, the present disclosure is not limited to the exemplary embodiments, and modifications and variations can be made thereto without departing from the technical idea of the present disclosure. Accordingly, the exemplary embodiments described herein are merely illustrative and are not intended to limit the scope of the present disclosure. The technical idea of the present disclosure is not limited by the exemplary embodiments. Therefore, it should be understood that the above-described embodiments are not limiting but illustrative in all aspects. The protection scope of the present disclosure must be analyzed by the appended claims and it should be analyzed that all technical aspects within the scope equivalent thereto are included in the appended claims of the present disclosure.

## Claims

1. A display apparatus (1000) comprising:
a first electrode (400);
a second electrode (700);
a plurality of organic layers between the first electrode and the second electrode; and
a metal layer (600) located on a particular organic layer (POL) among the plurality of organic layers,
wherein the metal layer (600) is configured to minimize a rise in driving voltage of the display apparatus (1000) which causes damage to the particular organic layer (POL) when the particular organic layer (POL) among the plurality of organic layers is exposed to a non-vacuum environment at least once during processes of stacking the plurality of organic layers and the second electrode (700) on the first electrode (400).

2. The display apparatus (1000) of claim 1, wherein the plurality of organic layers comprises an emission layer (EL), and
the particular organic layer (POL) is positioned between the emission layer (EL) and the second electrode (700).

3. The display apparatus (1000) of claim 2, wherein the metal layer (600) is configured to protect the particular organic layer (POL), and act as an auxiliary electrode for additionally supplying electrons to the emission layer (EL).

4. The display apparatus (1000) of claim 3, wherein the particular organic layer (POL) is made of a material that is more likely to be damaged by nitrogen or oxygen than that of an organic layer among the plurality of organic layers, which is between the emission layer (EL) and the first electrode (400).

5. The display apparatus (1000) of claim 4, wherein the particular organic layer (POL) has improved electronic characteristics than the organic layer between the emission layer (EL) and the first electrode (400).

6. The display apparatus (1000) of claim 5, wherein the particular organic layer (POL) is configured to inject or transport electrons to the emission layer (EL),
wherein, preferably, layers between the first electrode (400) and the particular organic layer (POL) are stacked through an in-line process,
wherein, further preferably, the metal layer (600) has a thickness determined based on a degree of potential damage to the particular organic layer (POL) and transmittance of light emitted from the emission layer (EL).

7. The display apparatus (1000) of claim 6, wherein the thickness of the metal layer (600) is between 10 Å and 40 Å.

8. The display apparatus (1000) of claim 6 or 7, wherein an average transmittance of the metal layer (600) is 90% or higher in a range of visible ray area.

9. The display apparatus (1000) of any one of claims 6 to 8, wherein the light emitted from the emission layer (EL) exits by penetrating the second electrode (700).

10. The display apparatus (1000) of any one of claims 6 to 9, wherein the first electrode (400) comprises a reflective layer (420) and a transparent layer (410, 430).

11. The display apparatus of claim 1, wherein:
the first electrode (400) comprises a reflective layer (420) and a transparent layer (410, 430);
the plurality of organic layers comprise:
a first organic layer (510) on the first electrode (400);
at least one emission layer (520) on the first organic layer (510); and
a second organic layer (530), which is the particular organic layer, on the at least one emission layer (520), the second organic layer (530) being made of a material having a higher electron mobility or electron affinity than that of the first organic layer (510);
the metal layer (600) is in contact with the second organic layer (530); and
the second electrode (700) comprises a transparent layer and is on the metal layer (600),
wherein, preferably, a thickness of the metal layer is between 10 Å and 40 Å,
wherein, further preferably, a transmittance of the metal layer is 90% or higher.

12. The display apparatus of claim 11, wherein the first organic layer (510) is a hole transport layer or a hole injection layer, and
the second organic layer (530) is an electron transport layer or an electron injection layer.

13. A method of manufacturing a display apparatus (1000), the method comprising:
forming a thin-film transistor (300) on a substrate (100);
forming a first electrode (400) to be connected to a source electrode (330) or a drain electrode (340) of the thin-film transistor (300);
forming a first organic layer on the first electrode (400) ;
forming at least one emission layer (EL) on the first organic layer;
forming a second organic layer on the emission layer (EL), the second organic layer being made of a material having improved electronic characteristics than that of the first organic layer;
forming a metal layer (600) contacting with the second organic layer on the second organic layer; and
forming a second electrode (700) on the metal layer (600),
wherein the forming the first organic layer, the forming the emission layer (EL), the forming the second organic layer and the forming the metal layer (600) are performed through an in-line process.

14. The method of claim 13, further comprising exposing the metal layer (600) to a non-vacuum environment at least once between the forming the metal layer (600) and the forming the second electrode (700).

15. The method of claim 13 or 14, wherein the metal layer (600) is configured to suppress the second organic layer from being damaged when exposed to the non-vacuum environment, suppress the second organic layer from being damaged during the forming the second electrode (700), and act as an auxiliary electrode for additionally supplying electrons to the emission layer (EL).
